(19) **Europäisches Patentamt / European Patent Office / Office européen des brevets**

(11) **EP 3 065 291 A1**

(12) **EUROPEAN PATENT APPLICATION**

(43) Date of publication:
07.09.2016 Bulletin 2016/36

(21) Application number: 15157158.5

(22) Date of filing: 02.03.2015

(51) Int Cl.:
*H02P 29/02* (2006.01)  *G01R 31/40* (2006.01)
*G01R 31/42* (2006.01)  *G01R 31/02* (2006.01)
*H02H 11/00* (2006.01)  *H02M 1/36* (2007.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicant: **ABB Technology Oy**
**00380 Helsinki (FI)**

(72) Inventors:
• **Nousiainen, Tero**
**00380 Helsinki (FI)**
• **Jurvanen, Janne**
**00380 Helsinki (FI)**
• **Maksimainen, Petri**
**00380 Helsinki (FI)**

(74) Representative: **Kolster Oy Ab**
**Iso Roobertinkatu 23**
**PO Box 148**
**00121 Helsinki (FI)**

(54) **Method for detecting disconnection of AC phase input of frequency converter of motor drive, and motor drive**

(57) A method for detecting a disconnection of an AC phase input of a three-phase frequency converter of a motor drive from an AC supply, and a motor drive configured to control a frequency converter (100) to supply power to a resistance from a DC intermediate circuit of the frequency converter, monitor a voltage of the DC intermediate circuit during the supplying of power to the resistance, and detect a disconnection of an AC phase input (U1, V1, W1) of the frequency converter (100) from the AC supply (400) on the basis of a fluctuation of the monitored voltage of the DC intermediate circuit (10) of the frequency converter.

**FIG. 3**

## Description

## Field of the invention

The invention relates to a method for detecting a disconnection of an AC phase input of a frequency converter of a motor drive, and to a motor drive.

## Background of the invention

A lift drive may be implemented by providing a lift (elevator) and a motor drive comprising at least one electric motor configured to drive the lift and a frequency converter configured to receive supply from an AC (Alternating Current) supply and to provide supply to the at least one electric motor.

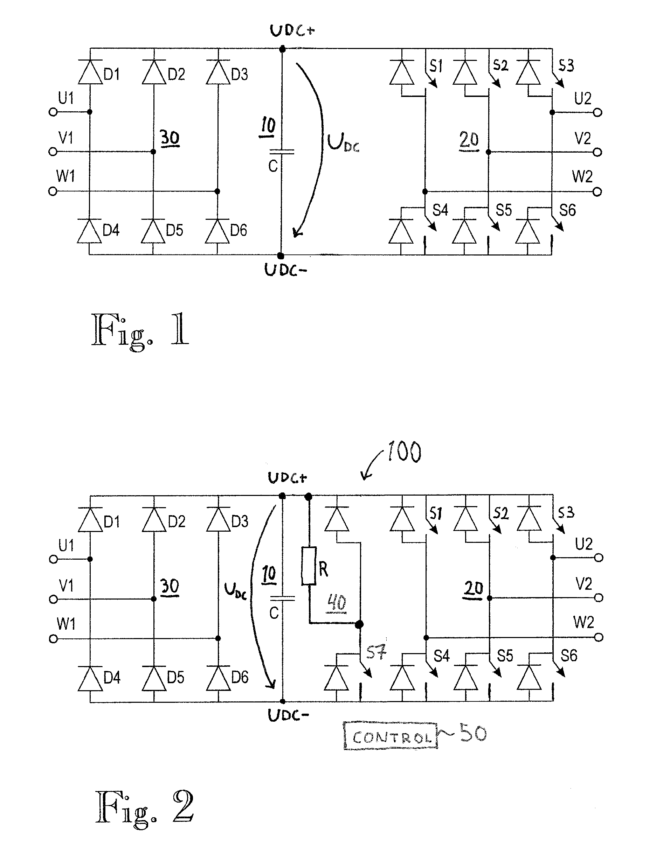

Figure 1 shows an example of a three-phase frequency converter. The exemplary frequency converter may be composed of a rectifier 30 and an inverter 20, between which a DC intermediate circuit 10 is provided. The rectifier 30 and the inverter 20 may also be located physically separately, and one rectifier may supply a plurality of inverters via a common DC intermediate circuit 10. An example of the rectifier 30 is a diode bridge D1 to D6, which obtains its power supply via phase inputs U1, V1, W1 from an AC (Alternating Current) source, which is a 50 or 60-Hz three-phase AC network, for instance, and an example of the inverter 20 is a semiconductor bridge implemented by means of transistors S1 to S6, such as IGBTs (Insulated-gate Bipolar Transistor) or FETs (Field-Effect Transistor), or other controllable semiconductor switches, which are controlled according to a modulation or control scheme used. The inverter 20 may be used to control power transferred from the intermediate circuit 10 of the frequency converter to its output U2, V2, W2. Accordingly, the power supply from the output U2, V2, W2 of the inverter 20 may be a three-phase AC output, for example. In a lift drive, the frequency converter may thus be used to control power transmitted from the AC supply to the electric motor driving the lift and, consequently, to control the movement of the lift.

In the operation of a lift drive, if one of the phase inputs U1, V1, W1 of the frequency converter gets disconnected from the AC supply, the lift typically needs to be stopped. Such disconnection of one of the phase inputs U1, V1, W1 of the frequency converter from the AC supply may be detected after the lift has already started to move, which may lead to a situation in which the lift is stopped between floors. This in turn is inconvenient, because possible passengers in the lift may need to be assisted out of the lift. A similar problem may occur in connection with drives of other types, such as hoists and cranes, where a disconnection of one of the phase inputs U1, V1, W1 of the frequency converter from the AC supply after the hoist or crane has already started to move may be problematic.

One solution to the above problem is to use special monitoring equipment which monitors the connections between the phase inputs U1, V1, W1 of the frequency converter and the AC supply. However, such solution based on equipment external to the frequency converter may be costly to provide and maintain and potentially prone to malfunctions.

## Brief description of the invention

An object of the invention is to provide a method and an apparatus for implementing the method so as to solve or at least alleviate the above problem. The object of the invention is achieved by a method, a computer program product, and a motor drive that are characterized by what is stated in the independent claims. Preferred embodiments of the invention are described in the dependent claims.

The invention is based on the idea of supplying power to a resistance with the frequency converter and monitoring a voltage of the DC intermediate circuit of the frequency converter during the supplying of power to the resistance with the frequency converter, whereby a disconnection of an AC phase input of the frequency converter from the AC supply can be detected on the basis of a fluctuation of the monitored voltage of the DC intermediate circuit of the frequency converter.

The solution of the invention provides the advantage that a disconnection of an AC phase input of the frequency converter from the AC supply can be detected with a simple arrangement and potentially even before the load is driven by the motor drive. Also, if an existing resistance, such as a brake resistance, is used, then no additional components are necessarily needed in order to implement the invention.

## Brief description of the figures

The invention will now be explained in greater detail in connection with preferred embodiments and with reference to the attached drawings, in which:

Figure 1 shows a circuit diagram of a frequency converter according to an embodiment;
Figure 2 shows a circuit diagram of a frequency converter according to an embodiment;
Figure 3 shows a block diagram of a motor drive according to an embodiment; and
Figure 4 shows a diagram illustrating system voltages according to an embodiment.

## Detailed description of the invention

The application of the invention is not restricted to any specific system, but it may be applied to various motor drives comprising a frequency converter. A load driven by the motor drive may comprise a lift, a hoist or a crane, for example. However, the invention may be utilized in connection with any kind of load or loads. In addition, the use of the invention is not restricted to any system utilizing a specific basic frequency or to any specific voltage level. Moreover, the invention may be applied to two-level or three-level converters, for example.

Figure 2 shows a circuit diagram of a main circuit of a frequency converter 100 according to an exemplary embodiment. It should be noted that the figure merely illustrates components necessary for understanding the invention. The number of various components may vary from that shown in the figure. The exemplary frequency converter 100 is a three-phase frequency converter and is composed of a rectifier 30 and an inverter 20, between which a DC intermediate circuit 10 is provided. The DC intermediate circuit 10 has a positive direct-current pole UDC+ and a negative direct-current pole UDC-. The voltage $U_{DC}$ of the DC intermediate circuit refers to a voltage between these two poles UDC+, UDC-. The rectifier 30 and the inverter 20 could be located physically separately, and one rectifier may supply a plurality of inverters via a common DC intermediate circuit 10. An example of the rectifier 30 is a diode bridge which comprises six diodes D1, D2, D3, D4, D5, D6, and which obtains its supply via phase inputs U1, V1, W1 from an AC source, which is a 50 or 60-Hz AC network, for instance. An example of the inverter 20 is a semiconductor bridge implemented by means of six controllable semiconductor switches S1, S2, S3, S4, S5, S6. Each of the six controllable semiconductor switches S1, S2, S3, S4, S5, S6 may have an antiparallel diode connected across the switch as illustrated. The controllable semiconductor switches S1 to S6 may be transistors, such as IGBTs (Insulated-gate Bipolar Transistor) or FETs (Field-Effect Transistor), or other controllable semiconductor switches. During normal operation of the inverter 20, the controllable semiconductor switches S1 to S6 are controlled according to a modulation or control scheme used to supply the output U2, V2, W2 of the inverter 20. Figure 1 further shows a control arrangement 50 which can control the controllable semiconductor switches S1 to S6, for example, and more generally the operation of the frequency converter 100, for example. The control connections between the control arrangement 40 and the controllable elements, such as the semiconductor switches S1 to S6, are not shown for the sake of clarity. The control arrangement 40 may perform measurements of or receive input signals regarding various quantities, such as the voltage $U_{DC}$ of the DC intermediate circuit 10, in order to perform the control of the frequency converter. Possible measuring arrangements for such quantities are not shown in the figure for the sake of clarity. Figure 1 further shows an example of the DC intermediate circuit 10 of the exemplary converter, which DC intermediate circuit 10 comprises a capacitance C, or generally an energy storage, connected between the positive direct-current pole UDC+ and the negative direct-current pole UDC-. The capacitance C of the intermediate circuit 10 may comprise one or more capacitors. The structure of the intermediate circuit 10 could also be different, depending on the circuit configuration used. The exemplary converter of Figure 2 further comprises a brake chopper 40. Conventionally brake choppers can be used in converters, such as frequency converters, for dissipating regenerated energy that cannot be fed back to the supplying network. For example, in a case where a motor supplied by the frequency converter 100 with the DC intermediate circuit 10 is rotated by a load connected to the motor, the motor acts as a generator and feeds power back to the supply. When the rectifying bridge 30 of the frequency converter is not configured to feed the regenerated energy back to the supplying network, the voltage of the DC intermediate circuit 10 starts to increase. When the voltage of the DC intermediate circuit 10 has increased to a certain limit, e.g. higher than the nominal voltage of the intermediate circuit, the brake chopper 40 may be activated and used to convert the electrical energy into heat in a brake resistance R in order to reduce the voltage of the DC intermediate circuit 10. Figure 2 shows an example of a main structure of the brake chopper 40 which comprises a controllable power semiconductor switch S7 connected in series with the brake resistance R between the two poles UDC+, UDC- of the DC intermediate circuit 10. The controllable semiconductor switch S7 and the brake resistance R may have an antiparallel diode connected across them as illustrated in the figure. The brake resistance R connected to the brake chopper 40 may be an external component and thus not necessarily part of the frequency converter or it can be integrated into the frequency converter. In normal operation of the brake chopper 40, the controllable semiconductor switch S7 can be used to control a current flowing between the poles Udc+, Udc- and through the brake resistance R. The operation of the brake chopper 40, i.e. the controllable semiconductor switch S7 thereof, may be controlled with the control arrangement 50, for example. The control connections between the control arrangement 50 and the controllable semiconductor switch S7 of the brake chopper 40 are not shown for the sake of clarity.

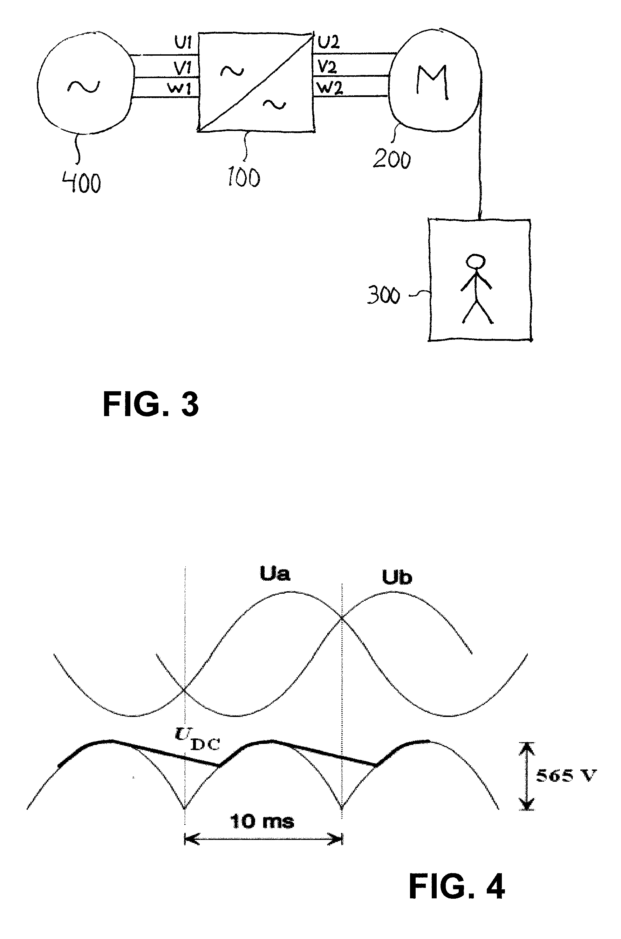

Figure 3 shows an example of a motor drive according to an embodiment. The exemplary motor drive comprises at least one electric motor 200, such as an asynchronous motor or a synchronous motor, or generally an AC motor, configured to drive a load 300, and a three-phase frequency converter 100, such as that described in connection with the example of Figure 2, configured to receive supply from an AC supply 400 and to provide supply to the at least one electric motor 200. The AC supply 400 may be a three-phase AC network, for example. According to an embodiment, the motor drive comprises a resistance R, comprising one or more resistors, for example. The resistance R may be part of the frequency converter 100 or a separate element. In the example of Figure 3, the load 300 driven by the motor drive comprises a lift, such as a passenger lift or a goods lift. Alternatively, the load 300 driven by the motor drive may comprise a hoist or a crane or another kind of load.

In normal operation, the capacitance C of the DC intermediate circuit 10 of the frequency converter 100 is charged to a peak value of line-to-line voltage $U_{LL}$ of the AC supply network 400 (for example, approximately 565 V in case of 400 V mains). When the inverter 20 is loaded, the DC intermediate circuit voltage $U_{DC}$ is approximately 540 V, which is the average of the six pulse voltage rectified by the three-phase diode bridge 30. If one of the phase inputs U1, V1, W1 of the frequency converter 100 is disconnected from the AC supply 400, the diode bridge 30 rectifies the line-to-line voltage between the remaining two phases. The peak value is still $\sqrt{2}U_{LL}$. Thus, the DC intermediate circuit voltage $U_{DC}$ does not change compared to the normal operation, if the inverter 100 is not loaded. However, instead of six pulses the voltage formed by the rectifier 30 contains two pulses and the input voltage of the rectifier 30 is zero when the line-to-line voltage is zero. Thus, the voltage over the capacitance C of the DC intermediate circuit 10 contains a ripple with frequency 2*(supply network 400 frequency), when the inverter 20 is loaded. The above situation is described in Figure 4 which shows the voltages $U_a$, $U_b$ of two healthy phase inputs U1, V1, W1 of the frequency converter 100 and the resulting voltage $U_{DC}$ of the DC intermediate circuit 10, when the inverter 20 is loaded. The frequency of the AC supply network 400 in the example of Figure 4 is 50 Hz and thus the period of the AC supply network 400 is 20 ms and, consequently, the period of the ripple in the voltage $U_{DC}$ of the DC intermediate circuit 10 is 10 ms as illustrated.

As a result of the above, a missing input phase, i.e. a disconnection of one of the phase inputs U 1, V1, W1 of the frequency converter 100 from the AC supply 400, can be detected by monitoring the fluctuation of the voltage $U_{DC}$ of the DC intermediate circuit 10. For example, if there is a difference between the maximum and minimum value of $U_{DC}$ during one period (for example, 1/50 Hz or 1/60 Hz depending on the frequency of the AC supply network), or generally fluctuation in the value of $D_{DC}$, it may indicate a disconnected phase input. However, a clear fluctuation can be observed only if sufficient power flows out of the DC intermediate circuit 10.

According to an embodiment, a disconnection of an AC phase input U1, V1, W1 of the three-phase frequency converter 100 of the lift drive from the AC supply 400, can be performed by a) supplying power to the resistance R from the DC intermediate circuit 10 of the frequency converter 100, b) monitoring the voltage $U_{DC}$ of the DC intermediate circuit 40 of the frequency converter 100 during the supplying of power to the resistance R from the DC intermediate circuit 10 of the frequency converter 100, and c) detecting a disconnection of an AC phase input (U1, V1, W1) of the frequency converter (100) from the AC supply (400) on the basis of a fluctuation of the voltage of the DC intermediate circuit (10) of the frequency converter.

For example, in the case of the exemplary frequency converter of Figure 2, power can be supplied from the DC intermediate circuit 10 of the frequency converter 100 to the brake resistance R by suitably controlling the controllable switch S7 of the brake chopper 40. The suitable amount of power supplied to the resistance R depends on the system characteristics. Thus, no specific values are given here. Generally, however, the amount of power supplied to the resistance R should be high enough such that the resulting ripple in the voltage $U_{DC}$ of the DC intermediate circuit 40 is detectable.

According to an embodiment, c) comprises detecting a disconnection of an AC phase input U1, V1, W1 of the frequency converter from the AC supply 400 in response to a difference between a maximum value of the monitored voltage of the DC intermediate circuit of the frequency converter and a minimum value of the monitored voltage of the DC intermediate circuit of the frequency converter, or a quantity indicative thereof, exceeding a predetermined threshold. Thus, the actual detection of the disconnection of an AC phase input U1, V1, W1 of the frequency converter from the AC supply 400 may be based on directly calculating a difference $max(U_{DC})-min(U_{DC})$ based on the monitored voltage $U_{DC}$ and determining whether such calculated difference (possibly filtered) exceeds the predetermined threshold. The value of the predetermined threshold may depend on the system characteristics. Thus, no definite values are given here. The value of the predetermined threshold may also depend on the amount of power supplied to the resistance R. As an example, the value of the threshold may be set to a value which allows a fluctuation of approximately 13% (peak-to-peak) in the voltage of the DC intermediate circuit 10, or more generally to a value in the range of approximately 8% to 16%, for example. A theoretical maximum ripple in the case of a three-phase supply is: (1-cos(pi/6))*U_(AC supply line-to-line)*sqrt(2) => 76 V (calculated by using a 400 V AC supply as an example). The predetermined threshold may also be adjustable by a user of the motor drive.

According to an embodiment, c) comprises extracting a ripple component having a frequency of 2*(a frequency of the AC supply) from the monitored voltage of the DC intermediate circuit of the frequency converter, and detecting a disconnection of an AC phase input U1, V1, W1 of the frequency converter 100 from the AC supply 400 in response to an amplitude of the extracted ripple component, or a quantity indicative thereof, exceeding a predetermined threshold. Accordingly, the actual detection of the disconnection of an AC phase input U1, V1, W1 of the frequency converter from the AC supply 400 may be based on using frequency domain methods. The ripple component having a frequency of 2*(a frequency of the AC supply) in the voltage $U_{DC}$ of the DC intermediate circuit 40 may be extracted by using a band-pass filter, for example, or moving average filtering. It is then possible to determine whether the amplitude of the extracted ripple component, or a quantity indicative thereof, exceeds the predetermined threshold. Again the value of the predetermined threshold may depend on the system characteristics, for example, and may also be adjustable by a user of the motor drive.

According to an embodiment, items a) to c) above may be performed in response to the motor drive receiving a command to drive the load 300. For example, in case of a motor drive driving a lift 300, such a command may refer to a command from a user, either inside the lift 300 or outside the lift, to the lift to move to a certain location, such as a certain floor, for example. Such a command may also refer to a command from a controlling system, such as the control arrangement 50, to the lift to move to a certain location without any user action involved. According to an embodiment, items a) to c) above may be performed before the load is driven. This is advantageous because this way the stopping of the load 300 abruptly, for example, can be avoided.

According to an embodiment, items a) and b) above are performed for a duration of at least one period of the AC supply 400. In a 50 Hz system one period corresponds to a time period of 1/50 Hz, i.e. 20 ms, for example. Thus, the maximum value and the minimum value or the ripple component having the frequency of 2*(a frequency of the AC supply) of the monitored voltage of the DC intermediate circuit during at least one period of the AC supply 400 may be considered in the detection, for example. In some cases it may be advantageous to apply a longer time period in order to make the detection more reliable. Accordingly, according to an embodiment, items a) and b) are performed for a duration of at least two periods of the AC supply.

According to an embodiment, items a) and b) above may be performed first for a predetermined time period, such as at least one period of the AC supply 400, and only after that item c) is performed based on the observed voltage of the DC intermediate circuit 10 of the frequency converter during the predetermined time period. Alternatively, it is possible to perform item c) simultaneously with items a) and b) such that the difference $max(U_{DC})-min(U_{DC})$, or a quantity indicative thereof, is continuously determined by continuously updating the values $max(U_{DC})$ and $min(U_{DC})$, or the ripple component having the frequency of 2*(a frequency of the AC supply) is continuously extracted, and compared with the predetermined threshold, for example.

According to an embodiment, if a disconnection of an AC phase input U1, V1, W1 of the frequency converter 100 from the AC supply 400 is detected, an alarm signal may be sent to an operator or a controller of the motor drive and/or the movement of the load 300 may be prevented by stopping the frequency converter 100, for example.

The control of the components of the motor drive according to the various embodiments described herein can be performed by or via the control arrangement 40, which can also perform e.g. the normal modulation control of the frequency converter 100. It is also possible to use additional or separate logical or physical units (not shown) for performing the control functionality of the invention. The functionality of the invention could, for example, be implemented using a separate logic arrangement, which could be independent of the normal modulation control of the frequency converter 100, for example. The control arrangement 40 may measure, or receive measuring information of, the voltage of the DC intermediate circuit 10 needed in the various embodiments.

The control arrangement 40 and/or a separate logic arrangement performing according to any one of the embodiments, or a combination thereof, can be implemented as one unit or as two or more separate units that are configured to implement the functionality of the various embodiments. Here the term 'unit' refers generally to a physical or logical entity, such as a physical device or a part thereof or a software routine. The control arrangement 40 according to any one of the embodiments may be implemented at least partly by means of one or more computers or corresponding digital signal processing (DSP) equipment provided with suitable software, for example. Such a computer or digital signal processing equipment preferably comprises at least a working memory (RAM) providing a storage area for arithmetical operations, and a central processing unit (CPU), such as a general-purpose digital signal processor. The CPU may comprise a set of registers, an arithmetic logic unit, and a CPU control unit. The CPU control unit is controlled by a sequence of program instructions transferred to the CPU from the RAM. The CPU control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or other apparatus implementing the invention, or a part thereof, may further comprise suitable input means for receiving e.g. measurement and/or control data, and output means for outputting e.g. control data. It is also possible to use analog circuits, programmable logic devices (PLD), or discrete electric components and devices for implementing the functionality according to any one of the embodiments. For example, the control arrangement 40 according to any one of the embodiments may be implemented at least partly by means of such analog circuits or programmable logic devices.

The invention can be implemented in existing system elements or by using separate dedicated elements or devices in a centralized or distributed manner. Present frequency converter devices, for example, can comprise programmable logic devices, or processors and memory that can be utilized in the functions according to embodiments of the invention. Thus, all modifications and configurations required for implementing an embodiment e.g. in existing frequency converters may be performed as software routines, which may be implemented as added or updated software routines. If at least part of the functionality of the invention is implemented by software, such software can be provided as a computer program product comprising computer program code which, when run on a computer, causes the computer or a corresponding arrangement to perform the functionality according to the invention as described above. Such a computer program code may be stored or generally embodied on a computer readable medium, such as a suitable memory, e.g. a flash memory or an optical memory, from which it is loadable to the unit or units executing the program code. In addition, such a computer program code implementing the invention may be loaded to the unit or units executing the computer program code via a suitable data network, for example, and it may replace or update a possibly existing program code.

It is obvious to a person skilled in the art that, as technology advances, the basic idea of the invention may be implemented in various ways. The invention and its embodiments are thus not restricted to the above examples but may vary within the scope of the claims.

**Claims**

1. A method for detecting a disconnection of an AC phase input of a three-phase frequency converter of a motor drive from an AC supply, the motor drive comprising at least one electric motor (200) configured to drive a load (300), the frequency converter (100) having a DC intermediate circuit (10) and configured to receive supply from the AC supply (400) and to provide supply to the at least one electric motor, and a resistance (R), the method comprising:

   a) supplying power to the resistance (R) from the DC intermediate circuit (10) of the frequency converter;
   b) monitoring a voltage of the DC intermediate circuit (10) of the frequency converter during the supplying of power to the resistance (R) from the DC intermediate circuit of the frequency converter; and
   c) detecting a disconnection of an AC phase input (U1, V1, W1) of the frequency converter (100) from the AC supply (400) on the basis of a fluctuation of the monitored voltage of the DC intermediate circuit (10) of the frequency converter.

2. A method according to claim 1, wherein step c) comprises detecting a disconnection of an AC phase input (U1, V1, W1) of the frequency converter (100) from the AC supply (400) in response to a difference between a maximum value of the monitored voltage of the DC intermediate circuit (10) of the frequency converter and a minimum value of the monitored voltage of the DC intermediate circuit of the frequency converter, or a quantity indicative thereof, exceeding a predetermined threshold.

3. A method according to claim 1, wherein step c) comprises:

   extracting a ripple component having a frequency of 2*(a frequency of the AC supply) from the monitored voltage of the DC intermediate circuit (10) of the frequency converter; and
   detecting a disconnection of an AC phase input (U1, V1, W1) of the frequency converter (100) from the AC supply (400) in response to an amplitude of the extracted ripple component, or a quantity indicative thereof, exceeding a predetermined threshold.

4. A method according to claim 1, 2 or 3, wherein steps a) to c) are performed in response to the motor drive receiving a command to drive the load (300).

5. A method according to claim 4, wherein steps a) to c) are performed before the load (300) is driven.

6. A method according to claim 5, wherein steps a) and b) are performed for a duration of at least one period of the AC supply.

7. A method according to claim 6, wherein steps a) and b) are performed for a duration of at least two periods of the AC supply.

8. A method according to any one of claims 1 to 7, wherein the load (300) comprises a lift, a hoist or a crane.

9. A computer program product comprising computer program code, wherein execution of the program code on a computer causes the computer to carry out the steps of the method according to any one of claims 1 to 8.

10. A motor drive comprising:

    at least one electric motor (200) configured to drive a load (300);
    a three-phase frequency converter (100) having a DC intermediate circuit (10) and configured to receive supply from an AC supply (400) and to provide supply to the at least one electric motor;
    a resistance (R);
    and control means (50) configured to:

       a) control the frequency converter (100) to supply power to the resistance (R) from the DC intermediate circuit (10) of the frequency converter;

b) monitor a voltage of the DC intermediate circuit (10) of the frequency converter during the supplying of power to the resistance (R) by the frequency converter (100) from the DC intermediate circuit of the frequency converter; and

c) detect a disconnection of an AC phase input (U1, V1, W1) of the frequency converter (100) from the AC supply (400) on the basis of a fluctuation of the monitored voltage of the DC intermediate circuit (10) of the frequency converter.

11. A motor drive according to claim 10, wherein during c) the control means (50) are configured to detect a disconnection of an AC phase input (U1, V1, W1) of the frequency converter (100) from the AC supply (400) in response to a difference between a maximum value of the monitored voltage of the DC intermediate circuit (10) of the frequency converter and a minimum value of the monitored voltage of the DC intermediate circuit of the frequency converter, or a quantity indicative thereof, exceeding a predetermined threshold.

12. A motor drive according to claim 10, wherein during c) the control means (50) are configured to:

extract a ripple component having a frequency of 2*(a frequency of the AC supply) from the monitored voltage of the DC intermediate circuit (10) of the frequency converter; and

detect a disconnection of an AC phase input (U1, V1, W1) of the frequency converter (100) from the AC supply (400) in response to an amplitude of the extracted ripple component, or a quantity indicative thereof, exceeding a predetermined threshold.

13. A motor drive according to claim 10, 11 or 12, wherein the control means (50) are configured to perform a) to c) in response to the motor drive receiving a command to drive the load (300).

14. A motor drive according to claim 13, wherein the control means (50) are configured to perform a) to c) before the load (300) is driven.

15. A motor drive according to claim 14, wherein the control means (50) are configured to perform a) and b) for a duration of at least one period of the AC supply (400).

16. A motor drive according to claim 15, wherein the control means (50) are configured to perform a) and b) for a duration of at least two periods of the AC supply (400).

17. A motor drive according to any one of claims 10 to 16, wherein the resistance (R) is a brake resistance.

18. A motor drive according to any one of claims 10 to 17, wherein the resistance (R) is integrated into the frequency converter (100).

19. A motor drive according to any one of claims 10 to 18, wherein the load (300) comprises a lift, a hoist or a crane.

Fig. 1

Fig. 2

**FIG. 3**

**FIG. 4**

Europäisches
Patentamt

European
Patent Office

Office européen
des brevets

## EUROPEAN SEARCH REPORT

Application Number

EP 15 15 7158

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/136130 A1 (NELSON MARK V [US] ET AL) 15 May 2014 (2014-05-15) | 1,2,4-7, 9-11, 13-16 | INV. H02P29/02 G01R31/40 |
| Y | * abstract * <br> * figure 2 * <br> * paragraphs [0005] - [0008], [0016] - [0021] * <br> * claims 1-6,11 * <br> ----- | 8,17-19 | G01R31/42 G01R31/02 H02H11/00 <br><br> ADD. H02M1/36 |
| Y | WO 2009/016267 A1 (KONE CORP [FI]; STOLT LAURI [FI]) 5 February 2009 (2009-02-05) <br> * abstract * <br> * page 16 * <br> * claims 1,9 * <br> ----- | 8,17-19 | |

TECHNICAL FIELDS
SEARCHED        (IPC)

H02P
G01R
H02H
H02M

The present search report has been drawn up for all claims

| Place of search | Date of completion of the search | Examiner |
|---|---|---|
| Munich | 16 September 2015 | Vanata, Daniela |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

           ...................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 15 15 7158

This annex lists the patent family members relating to the patent documents cited in the above-mentioned European search report.
The members are as contained in the European Patent Office EDP file on
The European Patent Office is in no way liable for these particulars which are merely given for the purpose of information.

16-09-2015

| Patent document cited in search report | Publication date | Patent family member(s) | Publication date |
|---|---|---|---|
| US 2014136130 A1 | 15-05-2014 | NONE | |
| WO 2009016267 A1 | 05-02-2009 | EP 2174410 A1 | 14-04-2010 |
| | | FI 20070583 A | 03-02-2009 |
| | | WO 2009016267 A1 | 05-02-2009 |

EPO FORM P0459

For more details about this annex : see Official Journal of the European Patent Office, No. 12/82